# EUROPEAN PATENT APPLICATION

(11) **EP 4 625 497 A1**
(43) Date of publication of application: **01.10.2025**
(21) Application number: 24166043.0
(22) Date of filing: 25.03.2024
(51) Int. Cl.: H01L 29/778, H01L 29/808, H01L 29/10

(54) **A CURRENT APERTURE VERTICAL ELECTRON TRANSISTOR**

(71) Applicant: Huawei Technologies Co., Ltd., Shenzhen, Guangdong 518129 (CN)
(72) Inventor: Cakmak, Huseyin, 80992 Munich (DE); Curatola, Gilberto, 80992 Munich (DE); Mouhoubi, Samir, 80992 Munich (DE)
(74) Representative: Roth, Sebastian

(57) **Abstract**

The present disclosure relates to a current aperture vertical electron transistor (CAVET). The CAVET may be a nitride based, for example, GaN-based device. The CAVET of this disclosure comprises a current blocking layer (CBL) and a diffusion blocking layer arranged on the CBL to prevent dopant diffusion from the CBL to a channel layer. An aperture is formed in the CBL and the diffusion blocking layer, and a heterostructure including the channel layer is formed in the aperture and on the diffusion blocking layer. In an implementation of the CAVET, the diffusion blocking layer comprises a semiconductor superlattice. In another implementation of the CAVET, a substrate of the CAVET is an engineered substrate 101, which comprises a 3C-SiC polycrystalline bottom layer and a single crystalline SiC or GaN top layer arranged on the bottom layer.

A backside drain contact may be formed on the substrate without using thermal annealing.

## Description

### TECHNICAL FIELD

The present disclosure relates to transistors for power semiconductor devices, for example, to nitride-based transistors. The disclosure particularly provides a current aperture vertical electron transistor (CAVET). The CAVET of this disclosure has several improvements over a conventional CAVET, for example, improvements concerning the substrate, and/or the drain contact, and/or its epitaxial layer stack including the channel layer.

### BACKGROUND

Traditionally, silicon (Si) is the mainstream of power semiconductor devices. However, its material limitations have constrained further improvements. As a result, there is an increasing demand for using wide bandgap (WBG) semiconductors, e.g., gallium nitride (GaN), silicon carbide (SiC), or gallium oxide (Ga₂O₃), which have bandgaps exceeding 3 eV.

Among the wide bandgap materials, GaN-based power semiconductor devices have been under extensive research, due to their superior material properties. These properties include a wide bandgap of 3.4 eV, a high critical electrical field of 3.3 MV/cm, and a high electron saturation velocity of 2.7×10⁷ cm/s. These properties make GaN a viable candidate for high power high frequency semiconductor devices.

At present, GaN-based power devices are classified into two main categories, which are distinguished based on the direction of the current flow. In a lateral GaN-based power device, the current flows laterally between source and drain contacts, wherein the contacts are all fabricated on the front side of a layer stack of the power device, which is typically manufactured on a Si or SiC substrate. In a vertical GaN-based power device, the current flows vertically between source and drain contacts, wherein the drain contact is formed on the backside of the layer stack of the power device. A conductive stack is required in such vertical power devices.

One of the main advantages of such vertical devices over lateral devices is their better breakdown voltage (V_{br}). The V_{br} of a vertical device can be raised by increasing the thickness of the layer stack, particularly the thickness of a drift layer of the stack, which is typically a low-doped GaN epitaxial layer. Hence, the V_{br} can be adjusted independent of the lateral size of the power device, which may result in higher wafer yield. Additionally, for a vertical power device, the peak electric field moves away from the surface into the bulk, and the current passes through a much larger volume, which improves the reliability of the device.

Different types of nitride-based vertical power devices have been proposed or developed, including p-i-n diodes, vertical GaN transistors, vertical GaN Schottky barrier diodes, and the CAVET. The concept of the CAVET merges a lateral two-dimensional electron gas (2DEG) channel with a vertical drift region. Hence, the CAVET can combine the advantages of the high conductivity of the 2DEG channel and the high V_{br} discussed above.

A conventional GaN-based CAVET typically utilizes a p-type GaN layer as a current blocking layer (CBL). In particular, magnesium doping is used to epitaxially grow the p-type GaN layer on an n-type GaN drift layer, wherein the p-type GaN layer is then patterned into the CBL. Then, an unintentionally doped GaN layer is regrown as a channel layer, i.e. as a current carrier layer, onto the CBL. Then, an AlGaN barrier layer and another p-GaN layer for threshold voltage adjustment are grown on the channel layer.

Precautionary measures are typically taken, in order to prevent Mg out-diffusion from the p-GaN CBL. Such diffused Mg would trap electrons in the channel layer, and may result in a current collapse. Moreover, non-activated Mg atoms in the CBL layer may cause a punch through current at the off-state from drain to source.

An example of such a precautionary measure is a low temperature grown GaN layer, which is provided as a magnesium blocking layer to suppress the Mg out-diffusion. However, this approach results in a decrease of the crystal quality of the GaN layer, and in a deactivation of Mg species due to high flow of ammonia (NH₃) during the GaN growth. As another example for a precautionary measure, a hybrid blocking layer (HBL) may be formed by using both p-GaN and carbon-doped GaN together. However, in this case, the carbon (C) doping in the GaN results in a decrease in the material quality. Further, both Mg and C can trap electrons with the potential result of a current collapse and reliability issues.

Another drawback of the conventional GaN-based CAVET is that n-type GaN is used as a substrate for the GaN epitaxy. The available size of such a GaN substrate is limited to 4-inch, and the price of it is extremely high.

Moreover, forming an Ohmic drain contact on the backside of the device stack is another important process step to realize the GaN-based CAVET. Thereby, types of metals for the drain contact, and process conditions and/or temperatures may vary depending on the substrate type and doping. Typically, n-type crystalline substrates are used with a moderate doping. However, this requires a high temperature annealing process, which leads to a high thermal budget that may be detrimental to the device.

### SUMMARY

In view of the above, an objective of this disclosure is to provide an improved CAVET. An objective is to design a more reliable and high-quality diffusion blocking layer, to suppress doping (e.g., Mg) out-diffusion from a CBL (e.g., p-GaN). Thus, an objective is to improve the performance and reliability of the CAVET. Another objective is to simplify a process of forming a backside drain contact, and to lower the used process temperatures, so as to decrease the thermal budget of the CAVET.

These and other objectives are achieved by the solutions of this disclosure, as described in the independent claims. Advantageous implementations are further described in the dependent claims.

A first aspect of this disclosure provides a CAVET, comprising a substrate; a drift layer of a first conductivity type arranged on or above the substrate; a CBL of a second conductivity type arranged on the drift layer; a diffusion blocking layer arranged on the current blocking layer, wherein the diffusion blocking layer comprises a semiconductor superlattice; an aperture through the current blocking layer and the diffusion blocking layer, wherein the aperture exposes a surface portion of the drift layer; a heterostructure arranged in the aperture on the exposed surface of the drift layer, and arranged on the diffusion blocking layer, wherein the heterostructure comprises a channel layer, and a barrier layer arranged on the channel layer, and a gate layer of the second conductivity type arranged on the barrier layer; wherein the CAVET further comprises a gate electrode arranged on the gate layer; two source electrodes arranged on the diffusion blocking layer, wherein each end of a channel formed in the channel layer at its interface to the barrier layer is electrically connected to one of the source electrodes; and a drain electrode arranged on a surface of the substrate that is opposite the drift layer.

The semiconductor superlattice, particularly when grown at high temperatures, provides a better barrier for preventing out-diffusion of dopants from the CBL into the channel layer - e.g. Mg out-diffusion - compared to a low-temperature grown conventional CBL. Thus, the superlattice improves the CAVET's performance. Further, the superlattice may have improved crystal quality.

In the CAVET of the first aspect, the heterostructure is arranged on the exposed surface of the drift layer, and in the aperture, and on the diffusion blocking layer. In particular, the heterostructure is arrange partly inside of the aperture (e.g., at least the channel layer is partly placed in the aperture, as it is the layer of the heterostructure arranged on the exposed drift layer) and partly placed outside of the aperture on a top surface of the diffusion blocking layer. The part of the heterostructure arranged in the aperture is surrounded by an inner surface or sidewall defining the aperture, wherein this inner surface or sidewall is formed by (side edges of) the CBL and the diffusion blocking layer. In the aperture, the heterostructure may be in direct contact with the CBL and diffusion blocking layer, into which the aperture is formed.

The first conductivity type may be n-type (caused by suitable n-dopants) and the second conductivity type may be p-type (caused by suitable p-dopants). However, this may be vice versa. An unintentionally doped layer refers to a layer that has impurities present, however, not by deliberate addition (i.e. doping) but as a result of the manufacturing process. These impurities can affect the electrical properties of the layer, but are not intentionally introduced so as to alter its conductivity, as is the case with purposefully doped layers.

In the CAVET of the first aspect, "on the substrate" means being in direct contact with the substrate, wherein "above the substrate" allows one or more layers to be arranged between, for example, the drift layer and the substrate. The same nomenclature may be used in this disclosure also regarding other layers arrange on or above another.

The CAVET is a semiconductor-based device, wherein the various layers including the drift layer, channel layer, barrier layer, CBL, diffusion blocking layer, and gate layer may be semiconductor-based, i.e., may be or may comprise semiconductor layer.

In an implementation form of the first aspect, the drift layer is a n-doped GaN layer; the current blocking layer is a p-doped GaN layer; the semiconductor superlattice comprises alternating aluminum nitride (A1N) layers and aluminum gallium nitride (AlGaN) layers, the channel layer is an undoped or unintentionally doped GaN layer and the barrier layer is an undoped or unintentionally doped AlGaN layer; and the gate layer is a p-doped GaN layer.

Accordingly, a GaN-based CAVET is provided. The CAVET of this disclosure may, however, be created in a different semiconductor material system as well. Possible material systems include: gallium arsenide (GaAs)/aluminum gallium arsenide (AlGaAs); indium gallium arsenide (InGaAs)/indium aluminum arsenide (InAlAs); SiC; or InP.

In an implementation form of the first aspect, the semiconductor superlattice further comprises GaN layers.

In an implementation form of the first aspect, an Al content in the AlGaN layers of the semiconductor superlattice is in a range of 1-99 %.

For example, the Al content may be in a range of 10-90%, or 20-80%, or 30-70%, or 40-60%. End points of these different exemplary ranges can be combined with each other to form further ranges.

In an implementation form of the first aspect, an Al content in the AlGaN layers of the semiconductor superlattice is graded.

The grading may thereby vary within any one of the above-mentioned ranges, or combinations thereof.

In an implementation form of the first aspect, each AlGaN layer of the semiconductor superlattice is arranged between an A1N layer and a GaN layer of the semiconductor superlattice; and the Al content of each AlGaN layer gradually decreases from 100% at the interface between the AlGaN layer and the A1N layer to 0% at the interface between the AlGaN layer and the GaN layer.

In an implementation form of the first aspect, a thickness of each semiconductor superlattice layer is in a range of 1-50 nm.

For example, the thickness may be in a range of 10-40 nm, or 15-35 nm, or 20-30 nm, or 24-26 nm. End points of these different exemplary ranges can be combined with each other to form further ranges.

In an implementation form of the first aspect, a total thickness of the semiconductor superlattice is in a range of 2-1000 nm.

For example, the thickness may be in a range of 10-800 nm, or 50-500 nm, or 100-200 nm, or 100-150 nm. End points of these different exemplary ranges can be combined with each other to form further ranges.

In an implementation form of the first aspect, the diffusion blocking layer further comprises a semiconductor layer of the second conductivity type arranged between the semiconductor superlattice and the heterostructure, wherein a doping profile in the semiconductor layer is graded.

In an implementation form of the first aspect, the semiconductor layer of the diffusion blocking layer is a carbon-doped GaN layer.

In an implementation form of the first aspect, the carbon doping of the carbon-doped GaN layer gradually decreases in a direction away from the semiconductor superlattice.

The additional semiconductor layer may further prevent the diffusion of doping from the CBL into the channel layer. Electron trapping due to carbon impurities in the stack may be suppressed by using the graded doping profile in the carbon-doped GaN layer. The carbon-doping may be gradually decreasing in the epitaxial growth direction. This approach may lower the carbon level closer to the channel layer and to the (2DEG) channel formed in the channel layer.

In an implementation form of the first aspect, a thickness of the carbon-doped GaN layer is in a range of 50-1500 nm.

For example, the thickness may be in a range of 100-1000 nm, or 200-800 nm, or 500-700 nm. End points of these different exemplary ranges can be combined with each other to form further ranges.

In an implementation form of the first aspect, the substrate is a SiC substrate of the first conductivity type.

In an implementation form of the first aspect, the substrate comprises a polycrystalline 3C-SiC bottom layer and a single crystalline SiC or GaN top layer arranged on the bottom layer; and the drain contact is arranged on the bottom layer.

In an implementation form of the first aspect, the 3C-SiC bottom layer is degenerately doped with a doping concentration above 1e20 cm⁻³.

This engineered substrate does not only simplify the drain Ohmic contact formation, but also improves a contact resistance, thus yielding a much better performance of the CAVET.

A second aspect of this disclosure provides a CAVET comprising a substrate of the first conductivity type comprising a 3C-SiC polycrystalline bottom layer and a single crystalline SiC or GaN top layer arranged on the bottom layer; a GaN drift layer of a first conductivity type arranged on or above the SiC or GaN top layer of the substrate; a GaN current blocking layer of a second conductivity type arranged on the GaN drift layer; a diffusion blocking layer arranged on the GaN current blocking layer; an aperture through the GaN current blocking layer and the diffusion blocking layer, wherein the aperture exposes a surface portion of the GaN drift layer; a heterostructure arranged in the aperture on the exposed surface of the GaN drift layer, and arranged on the diffusion blocking layer, wherein the heterostructure includes a GaN channel layer and an AlGaN barrier layer; a GaN gate layer of the second conductivity type arranged on the barrier layer; a gate electrode arranged on the GaN gate layer; two source electrodes arranged on the diffusion blocking layer, wherein each end of a channel formed in the channel layer at its interface to the barrier layer is electrically connected to one of the source electrodes; and a drain electrode arranged on a surface of the bottom layer of the substrate that is opposite the top layer.

The substrate of the CAVET of the second aspect simplifies the drain contact formation, and also improves a contact resistance, thus yielding a much better performance of the CAVET.

In an implementation of the second aspect, the diffusion blocking layer comprises a semiconductor superlattice that includes alternating AlGaN layers, GaN layer and A1N layers.

This superlattice prevents diffusion of dopants from the CBL into the channel layer, for example, of Mg as described above for the first aspect. The superlattice could also include only AlGaN and A1N layers, alternatingly arranged. The CAVET of the second aspect can be provided with the features (implementation forms) of the CAVET of the first aspect and vice versa.

A third aspect of this disclosure provides a method for fabricating a CAVET, the method comprising forming a substrate; forming a drift layer of a first conductivity type on or above the substrate; forming a current blocking layer of a second conductivity type on the drift layer; forming a diffusion blocking layer on the current blocking layer, wherein the diffusion blocking layer comprises a semiconductor superlattice; forming an aperture through the current blocking layer and the diffusion blocking layer, wherein the aperture exposes a surface portion of the drift layer; forming a heterostructure in the aperture on the exposed surface of the drift layer, and on the diffusion blocking layer, wherein forming the heterostructure comprises forming a channel layer, and forming a barrier layer on the channel layer, and forming a gate layer of the second conductivity type on the barrier layer; and forming a gate electrode on the gate layer; wherein the method further comprises forming two source electrodes on the diffusion blocking layer, wherein each end of a channel formed in the channel layer at its interface to the barrier layer is electrically connected to one of the source electrodes; and forming a drain electrode on a surface of the substrate that is opposite the drift layer; wherein the semiconductor superlattice of the diffusion blocking multilayer is grown at a temperature in a range of 900-1200 °C.

In an implementation form of the third aspect, the drift layer is a n-doped gallium nitride, GaN, layer; the current blocking layer is a p-doped GaN layer; the semiconductor superlattice comprises alternating AlN layers and AlGaN layers, the channel layer is an undoped or unintentionally doped GaN layer and the barrier layer is an undoped or unintentionally doped AlGaN layer; and the gate layer is a p-doped GaN layer.

In an implementation form of the third aspect, the semiconductor superlattice further comprises GaN layers.

In an implementation form of the third aspect, an Al content in the AlGaN layers of the semiconductor superlattice is set to be in a range of 1-99 %.

In an implementation form of the third aspect, an Al content in the AlGaN layers of the semiconductor superlattice is made graded.

In an implementation form of the third aspect, each AlGaN layer of the semiconductor superlattice is formed between an AlN layer and a GaN layer of the semiconductor superlattice; and the Al content of each AlGaN layer is made to gradually decrease from 100% at the interface between the AlGaN layer and the A1N layer to 0% at the interface between the AlGaN layer and the GaN layer.

In an implementation form of the third aspect, a thickness of each semiconductor superlattice layer is set to be in a range of 1-50 nm.

In an implementation form of the third aspect, a total thickness of the semiconductor superlattice is set to be in a range of 2-1000 nm.

In an implementation form of the third aspect, the diffusion blocking layer further comprises a semiconductor layer of the second conductivity type formed between the semiconductor superlattice and the heterostructure, wherein a doping profile in the semiconductor layer is made graded.

In an implementation form of the third aspect, the semiconductor layer of the diffusion blocking layer is a carbon-doped GaN layer.

In an implementation form of the third aspect, the carbon doping of the carbon-doped GaN layer is made to gradually decrease in a direction away from the semiconductor superlattice.

In an implementation form of the third aspect, a thickness of the carbon-doped GaN layer is set to be in a range of 50-1500 nm.

In an implementation form of the third aspect, the substrate is a SiC substrate of the first conductivity type.

In an implementation form of the third aspect, the substrate comprises a polycrystalline 3C-SiC bottom layer and a single crystalline SiC or GaN top layer formed on the bottom layer; and the drain contact is formed on the bottom layer.

In an implementation form of the third aspect, the 3C-SiC bottom layer is degenerately doped with a doping concentration above 1e20 cm⁻³.

The method of the third aspect provides the same advantages as described above for the CAVET of the first aspect. The method may have exemplary implementations as described above for the CAVET of the first aspect.

A fourth aspect of this disclosure provides a method for fabricating a CAVET, the method comprising forming a substrate of the first conductivity type comprising a 3C-SiC polycrystalline bottom layer and a single crystalline SiC or GaN top layer arranged on the bottom layer; forming a GaN drift layer of a first conductivity type on or above the SiC or GaN top layer of the substrate; forming a GaN current blocking layer of a second conductivity type on the GaN drift layer; forming a diffusion blocking layer on the GaN current blocking layer; forming an aperture through the GaN current blocking layer and the diffusion blocking layer, wherein the aperture exposes a surface portion of the GaN drift layer; forming a heterostructure in the aperture on the exposed surface of the GaN drift layer, and on the diffusion blocking layer, wherein forming the heterostructure comprises forming a GaN channel layer, and forming an AlGaN barrier layer on the GaN channel layer, and forming a GaN gate layer of the second conductivity type on the AlGaN barrier layer; wherein the method further comprises forming a gate electrode on the GaN gate layer; forming two source electrodes on the diffusion blocking layer, wherein each end of a channel formed in the GaN channel layer at its interface to the AlGaN barrier layer is electrically connected to one of the source electrodes; and forming a drain electrode on a surface of the bottom layer of the substrate that is opposite the top layer; wherein the drain electrode is formed using an annealing-free process on the 3C-SiC bottom layer of the substrate.

In an implementation form of the second aspect, the diffusion blocking layer comprises a semiconductor superlattice that includes alternating AlGaN layers, GaN layer and A1N layers.

The method of the fourth aspect provides the same advantages as described above for the CAVET of the second aspect. The method may have exemplary implementations as described above for the CAVET of the second aspect. The method of the fourth aspect can be provided with the features (implementation forms) of the method of the third aspect and vice versa.

A high-Temperature free Ohmic contact formation can be achieved in this way, that is, by utilizing a substrate that is also called engineered substrate in this disclosure. The engineered substrate may be composed of two or more layers namely 'base' (bottom) and 'active' (top) layer. The base layer supports both mechanical support as well as electrical support. The present disclosure's engineered substrate, with the degenerately doped base layer, provides a good electrical connection to the drain contact without high-temperature. This approach significantly simplifies device manufacturing, lowers costs, and improve device performance.

### BRIEF DESCRIPTION OF DRAWINGS

The above described aspects and implementation forms are explained in the following description in relation to the enclosed drawings, in which:
- FIG. 1: shows a CAVET according to this disclosure with a semiconductor superlattice as a diffusion blocking layer arranged on a CBL.
- FIG. 2: shows a CAVET according to this disclosure with a diffusion blocking layer comprising a semiconductor superlattice and an additional semiconductor layer.
- FIG. 3: shows a CAVET according to this disclosure with a doping implementation before epitaxial growth in the substrate.
- FIG. 4: shows a CAVET according to this disclosure with an engineered substrate having a bottom layer and a top layer.
- FIG. 5: shows an exemplary implementation of the semiconductor superlattice with two superlattice layers.
- FIG. 6: shows an exemplary implementation of the semiconductor superlattice with three superlattice layers.
- FIG. 7: shows an exemplary implementation of the additional semiconductor layer of the diffusion blocking layer.
- FIG. 8: shows a method for fabricating a CAVET with a semiconductor superlattice in the diffusion blocking layer, according to this disclosure.
- FIG. 9: shows a method for fabricating a CAVET with an engineered substrate, according to this disclosure.

### DETAILED DESCRIPTION OF EMBODIMENTS

In the following, various exemplary embodiments of a CAVET 100 according to this disclosure are described. Features described in an embodiment of the CAVET 100 are compatible with features described in other embodiments of the CAVET 100. The CAVET 100 of this disclosure is semiconductor-based, i.e., it comprises various semiconductor layers. The CAVET 100 of this disclosure may be implemented in different kinds of semiconductor material systems, as they are known in the art. The CAVET 100 may be suitable for semiconductor power device applications. The CAVET 100 may be nitride based, in particular, may be based on GaN technology. The CAVET 100 may be a GaN power semiconductor device suitable for the >1 kV range. Thus, it may be suitable for industrial applications like electric vehicle (EV) charging or photo voltaic (PV) inverters. In particular, the CAVET 100 may be designed for the 1-200 kV range.

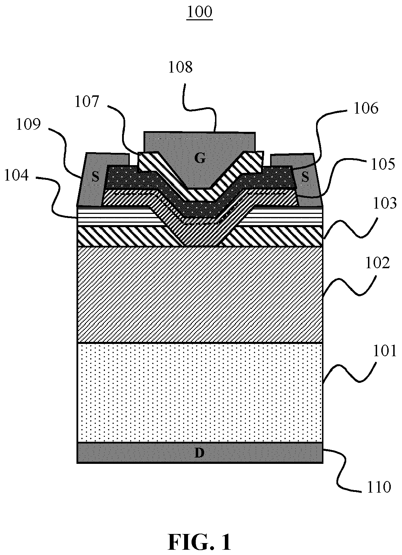

FIG. 1 shows an exemplary CAVET 100 according to this disclosure. The CAVET 100 comprises a substrate 101, which may be a SiC substrate or may be a SiC-based and/or engineered substrate as described later. The CAVET 100 further comprises a drift layer 102 of a first conductivity type (e.g., n-type), which is arranged on or above the substrate 101. The drift layer 102 may be a GaN drift layer. The drift layer 102 may comprise a portion that is higher doped (e.g., n⁺⁺) than the rest of the drift layer 102, wherein said portion may function as a current spreading layer. The drift layer 102 may have a thickness between 3-8 µm, and the current spreading layer, if present, may occupy 0.1-1 µm of this thickness. The current spreading layer, if present, is arranged in the upper part (having the largest distances to the substrate 101) of the drift layer 102. A doping of the drift layer 102 may be in the order of 1e16 cm⁻³ - 2e16 cm⁻³, wherein the current spreading layer may be higher doped than this.

The CAVET 100 further comprises a CBL 103 of a second conductivity type (e.g., p-type), which is arranged on the drift layer 102. The CBL 103 may also be referred to as a p-well. The CBL 103 may be a GaN layer. The CAVET 100 further comprises a diffusion blocking layer, which is arranged on the CBL 103, wherein the diffusion blocking layer comprises a semiconductor superlattice 104. The semiconductor superlattice 104 may comprise alternating AlGaN and A1N layers, or may comprise alternating GaN, AlGaN, and AlN layers, as will be described later. An aperture or trench is formed through the CBL 103 and the diffusion blocking layer, such that the aperture exposes a surface portion of the drift layer 102 beneath. Notably, in the final CAVET 100, the aperture is filled again by other material, which will become clear from the following description.

The CAVET 100 further comprises a hetero structure, in particular a semiconductor heterostructure, which is arranged in the aperture and on the exposed surface of the drift layer 102. The heterostructure is also arranged on the diffusion blocking layer, in FIG. 1 particularly on the superlattice 104. The heterostructure may fill the entire aperture, and may extends upwards from the aperture. The heterostructure may have a shape following the sidewalls defined by the CBL 103 and diffusion blocking layer in the aperture, such that it extends from the aperture onto the diffusion blocking layer. Thus, as shown, the hetero structure may have shape (in the cross-sectional view shown in FIG. 1), which resembles a U-shape or V-shape. The heterostructure comprises a channel layer 105, for instance a GaN layer, and a barrier layer 106, for instance an AlGaN layer, on the channel layer 105. The heterostructure further comprises a gate layer 107 of the second conductivity type, for instance a GaN layer, which is arranged on the barrier layer 106.

The CAVET 100 further comprises a gate electrode 108 arranged on the gate layer 107 of the heterostructure. It further comprises two source electrodes 109, which are respectively arranged on the diffusion blocking layer, such that each source electrode 109 is electrically connected to one of two ends of a channel, which is formed in the channel layer 105 at the interface between the channel layer 105 and the barrier layer 106 (the channel is indicated as a dashed line in FIG. 1). The CAVET 100 further comprises a drain electrode 110, which is arranged on a surface of the substrate 101 opposite the drift layer 102. That is, the substrate 101 is arranged between the drain electrode 110 and the drift layer 102.

In the CAVET 100, a current can flow between the source electrodes 109 and the drain electrode 110, wherein the current flows through the channel formed in the channel layer 105 (a 2DEG in this case) and further flows vertically in the drift layer 102 to the drain electrode 110. Thereby, the current passes through the aperture in the CBL 103. The gate electrode 108 can be used to pinch-off at least the channel, and thus to control the current flow in the CAVET 100.

The semiconductor superlattice 104 is able to suppress out-diffusion of dopants from the CBL 103 into the channel layer 105, particularly of Mg in case of an Mg doped p-GaN layer 103. This leads to a better channel quality (higher mobility 2DEG), and thus better performance of the CAVET 100. Especially when compared to a conventional CAVET with a conventional diffusion blocking (stopping) layer, a performance increased is significant. The semiconductor superlattice 104 may be grown at higher temperatures, for example, than a conventional diffusion blocking layer, which improves the crystal quality of the layer.

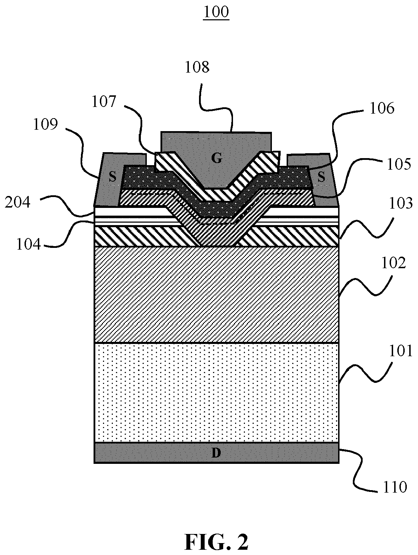

FIG. 2 shows another exemplary CAVET 100 according to this disclosure, which is based on the CAVET 100 shown in FIG. 1. Same elements are labelled with the same reference signs, may be implemented likewise, and are not redundantly described.

In the CAVET 100 shown in FIG. 2, the diffusion blocking layer comprises an additional semiconductor layer 204 of the second conductivity type. This semiconductor layer 204 is arranged between the semiconductor superlattice 104 of the diffusion blocking layer and the (channel layer 105 of the) heterostructure. The semiconductor layer 204 may be a doped GaN layer, for instance, a carbon-doped GaN layer. This can further improve the blocking characteristics of the diffusion blocking layer. A doping profile in the semiconductor layer 204 may be graded. For example, the doping in the semiconductor layer 204 may gradually decrease in a direction away from the semiconductor superlattice 104 towards the channel layer 105, i.e., in epitaxial growth direction. A thickness of the semiconductor layer 204 can be in a range of 50-1500 nm. This may compare to a superlattice thickness in a range of 2-1000 nm. The semiconductor superlattice 104 and the semiconductor layer 204 may have the same thickness.

The semiconductor layer 204 may prevent doping-related trapping in the current carrying layer, i.e., the channel layer 105. This may improve the quality of the 2DEG. The doping profile of the semiconductor layer, e.g. C-content, may be lowered closer to the channel, to achieve a higher quality 2DEG.

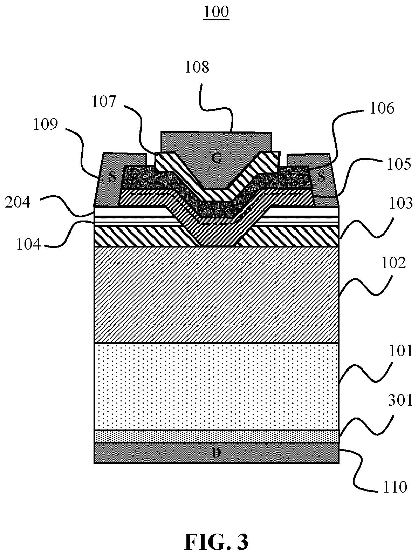

FIG. 3 shows another exemplary CAVET 100 according to this disclosure, which is based on the CAVET 100 shown in FIG. 2. Same elements are labelled with the same reference signs, may be implemented likewise, and are not redundantly described.

In the CAVET 100 shown in FIG. 3, the substrate 101 is a SiC substrate of the first conductivity type. The substrate 101 may be an n-type SiC substrate. Moreover, the substrate 101 may include an n-type implementation 103 at its interface to the drain electrode 110. The aim of this n-type implantation (e.g., achieved by implanting nitrogen, phosphor, etc.) at the backside of the substrate 101 is to have a degenerate n-type doping (e.g. 1e20 cm⁻³) at the interface, which allows removing a high-temperature annealing process when forming the drain electrode 110 on the substrate backside.

In an example of the CAVET 100 shown in FIG. 2, the thickness of the n-type SiC substrate may be 300-400 µm, e.g. 350 µm, and the substrate doping may be 5e18cm⁻³. The implantation performed at the backside of the substrate 101 may be done with nitrogen, so as to achieve a dopant concentration of 1e20cm⁻³.

The carbon-doped semiconductor layer 204 may be around 1000 nm thick, and the carbon doping may be gradually change from 1e19cm⁻³ (at the bottom of the layer 204, i.e. near the superlattice 104) to 1e16cm⁻³ (on the top of the layer 204, i.e. near the channel layer 105).

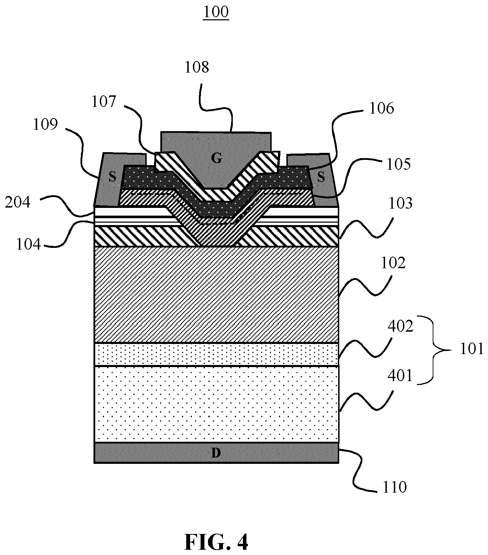

FIG. 4 shows an exemplary CAVET 100 according to this disclosure, which is based on the CAVET 100 shown in FIG. 2. Same elements are labelled with the same reference signs, may be implemented likewise, and are not redundantly described.

In the CAVET 100 shown in FIG. 4, the substrate 101 comprises a polycrystalline 3C-SiC bottom layer 401 and a single crystalline SiC or GaN top layer 402, which is arranged on the bottom layer 401. The drain contact 110 is arranged on the bottom layer 401 as well (backside). The 3C-SiC bottom layer 401 may be degenerately doped with a doping concentration of about 1e20 cm⁻³ or above. That is, the CAVET 100 shown in FIG. 4 differs from the previously shown CAVETs 100 in the utilization of a new generation of substrate, which is called engineered substrate. The design of the engineered substrates may be customized based on the application intended for the CAVET 100.

The aim of the single crystalline top layer 402 of the substrate 101 is a high quality GaN epitaxial layer growth, and the purpose of the poly-crystalline 3C-SiC bottom layer 401 is to enable a high-temperature annealing free formation of the drain electrode 110.

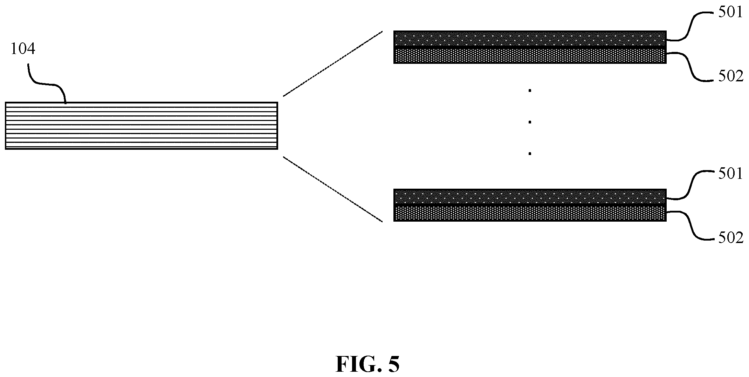

FIG. 5 shows an exemplary implementation of the semiconductor superlattice 104, which is applicable to the CAVET 100 shown in any one of the previous figures. The superlattice 104 in this case comprises two different types of superlattice layers.

In particular, the semiconductor superlattice 104 comprises alternating A1N layers 502 and AlGaN layers 501. For example, the superlattice 104 is composed of a periodic arrangement of alternating thin film epitaxial layers composed of an AlN/AlGaN superlattice structure. Both the A1N layer 502 and the AlGaN layer 501 thicknesses can vary, for example, from 1-50 nm in the superlattice structure. An Al content in the AlGaN layer(s) 501 can vary from 1-99%. The total thickness of the superlattice 104 can vary from 2-1000 nm or thicker when required. In a particular example, the AlN layer 502 thickness may be 10 nm, the AlGaN layer 501 thickness may be 20 nm with 8% Al in the layers, and the total thickness of the superlattice 104 may be 300 nm.

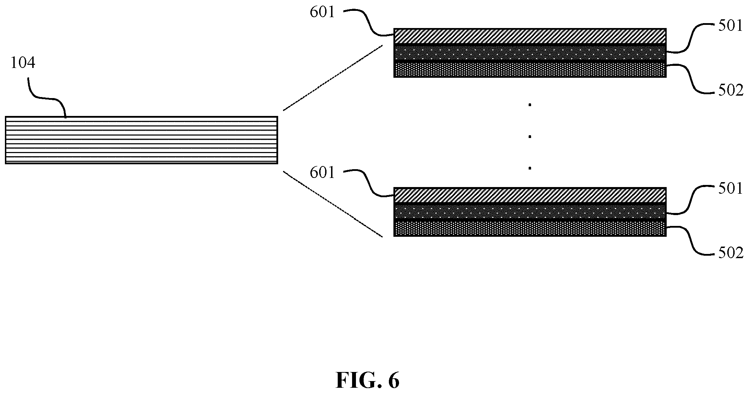

FIG. 6 shows an exemplary implementation of the semiconductor superlattice 104, which is applicable to the CAVET 100 of any one of FIGs. 1-4. The superlattice 104 in this case comprises three different types of superlattice layers.

In particular, the semiconductor superlattice 104 further comprises GaN layers 601. That is, the superlattice 104 of FIG. 6 differs from that of FIG. 5 in the number of layer types in the superlattice structure. Each of the A1N layer 502, GaN layer 601, and AlGaN layer 501 thicknesses can vary from 1-50 nm in the superlattice structure. An Al content in the AlGaN layer 501 can be 1- 99%. The total thickness of the superlattice 104 can vary from 3-1000 nm or thicker when required. In a particular example, the A1N layer 502 thickness may be 10 nm, the AlGaN layer 501 thickness may be 20 nm with 8% Al, and the GaN layer 601 thickness may be 20 nm in the superlattice 104, and the total thickness of the superlattice 104 may be 500 nm.

In the superlattice 104 shown in FIG. 6, the the Al content of each AlGaN layer 501 may also gradually decrease from 100% at the interface between the AlGaN layer 501 and the A1N layer 502, to 0% at the interface between the AlGaN layer 501 and the GaN layer 601. In this exemplary implementation, instead of using a fixed Al content in the AlGaN layer(s) 501, graded AlGaN layer(s) 501 are introduced. The AlGaN layer 501 may provide a smooth transition from the lower A1N layer 502 to the upper GaN layer 601 of the superlattice structure. The total thickness of the superlattice 104 can vary from 3-1000 nm or thicker when required. In a particular example, the AlN layer 501 thickness may be 10 nm, the graded AlGaN layer 502 thickness may be 20 nm, and the GaN layer 601 thickness may be 20 nm in the superlattice 104. The total thickness of the superlattice 104 may be 500 nm.

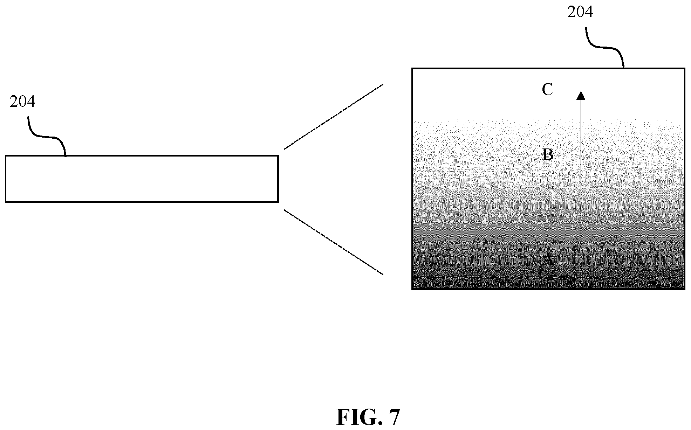

FIG. 7 shows an exemplary implementation of the additional semiconductor layer 204 of the diffusion blocking layer, which is applicable to the CAVET 100 shown in any one of the FIGs. 1-4, and can be combined with either superlattice 104 of FIG. 5 and FIG. 6.

The semiconductor layer 204 is a GaN layer with a graded carbon doping (GaN:C grading). The carbon doping is lowered and decreasing to its minimum when approaching the channel layer 105 (decreasing from A to B and further to C, as indicated in FIG. 7), in this case the unintentionally doped GaN layer. In a particular example, the thickness of the carbon-doped layer may be 1000 nm, and the carbon doping may be gradually changing from 1e19cm⁻³ (at the bottom of the layer 204, i.e. near the superlattice 104) to 1e16cm⁻³ (at the top of the layer 204, i.e. near the channel layer 105).

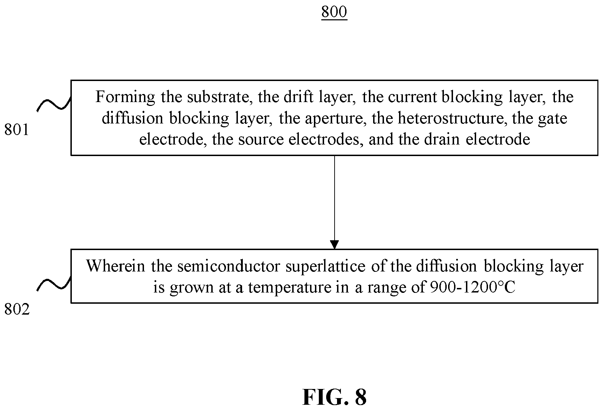

FIG. 8 shows a method 800 for fabricating an exemplary CAVET 100 comprising a semiconductor superlattice 104, according to this disclosure.

The method 800 comprises a general step 801 of forming the substrate 101, the drift layer 102, the CBL 103, the diffusion blocking layer 104, the aperture, the heterostructure, the gate electrode 108, the source electrodes 109, and the drain electrode 110. In particular, in the general step 801, first the substrate 101 may be formed, then the drift layer 102 of the first conductivity type may be formed on or above the substrate 101, then the CBL 103 of the second conductivity type may be formed on the drift layer 102, and then the diffusion blocking layer may be formed on the CBL 103, wherein the diffusion blocking layer comprises the semiconductor superlattice 104. Further, the aperture is formed through the CBL 103 and the diffusion blocking layer, wherein the aperture exposes a surface portion of the drift layer 102, and the heterostructure is formed in the aperture on the exposed surface of the drift layer 102 and on the diffusion blocking layer, respectively. The forming of the heterostructure comprises forming the channel layer 105, forming the barrier layer 106 on the channel layer 105, and forming the gate layer 107 of the second conductivity type on the barrier layer 106. The gate electrode 108 is formed on the gate layer 107, and the two source electrodes 109 are formed on the diffusion blocking layer. Each end of a channel formed in the channel layer 105 at its interface to the barrier layer 106 is electrically connected to one of the source electrodes 109, and the drain electrode 110 is formed on the surface of the substrate 101 that is opposite the drift layer 102.

In the method 800, when forming the superlattice 104 in the general step 801, a specific step 802 of growing the semiconductor superlattice 104 on the CBL 103 is performed at a temperature in a range of 900-100°C.

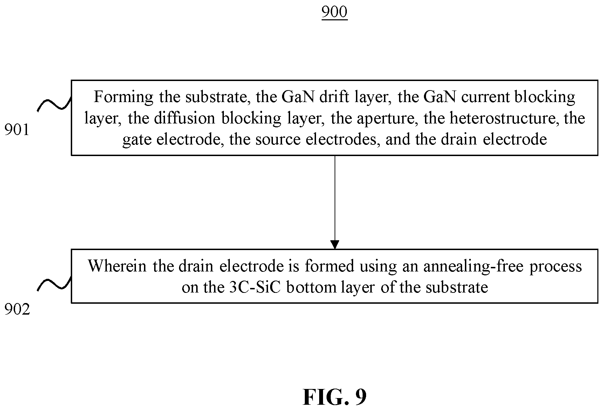

FIG. 9 shows a method 900 for fabricating an exemplary CAVET 100 with an engineered substrate 101, which comprises a 3C-SiC polycrystalline bottom layer 401 and a single crystalline SiC or GaN top layer 402 arranged on the bottom layer 401, according to this disclosure.

The method 900 comprises a general step 901 of forming the substrate 101, the GaN drift layer 102, the GaN CBL 103, the diffusion blocking layer 104, the aperture, the heterostructure, the gate electrode 108, the source electrodes 109, and the drain electrode 110. In particular in step 801, first the substrate 101 may be formed, then the GaN drift layer 102 of the first conductivity type may be formed on or above the SiC or GaN top layer 402 of the substrate 101, then the GaN CBL 103 of the second conductivity type may be formed on the GaN drift layer 102, and then the diffusion blocking layer may be formed on the CBL 103. Further, the aperture is formed through the CBL 103 and the diffusion blocking layer, wherein the aperture exposes a surface portion of the GaN drift layer 102, and the heterostructure is formed in the aperture on the exposed surface of the GaN drift layer 102 and on the diffusion blocking layer, respectively. Forming the heterostructure comprises forming the GaN channel layer 105, forming the AlGaN barrier layer 106 on the channel layer 105, and forming the GaN gate layer 107 on the AlGaN barrier layer 106. The method 900 further comprises forming the gate electrode 108 on the GaN gate layer 107, and forming the two source electrodes 109 on the diffusion blocking layer, wherein each end of a channel formed in the channel layer 105 at its interface to the barrier layer 106 is electrically connected to one of the source electrodes 109. The drain electrode 110 is formed on the surface of the substrate 101 that is opposite the top layer 402.

In the method 900, when forming the drain electrode 110 on the 3C-SiC bottom layer 401 of the substrate 101, an annealing-free process is used, e.g., a process without rapid thermal anneal. This is in contrast to a conventional process of forming a backside drain electrode.

In summary, the superlattice 104 of the diffusion blocking layer proposed in this disclosure leads to an improved device reliability of the CAVET 100. This is achieved by enabling higher growth temperatures compared to conventional diffusion blocking layers, and thus an improved material quality of the diffusion blocking layer. Further, better diffusion blocking characteristics, particularly as Mg stopper, are achieved as well. Further, the (optional) additional semiconductor layer 204 of the diffusion blocking layer proposed in this disclosure, for example, the graded carbon-doped GaN layer, may lead to less trapping close to the 2DEG channel, due to a lower carbon-content closer to the channel. The additional semiconductor layer 204 further improves the diffusion blocking capability. Further, the engineered substrate 101 proposed in this disclosure enables a simplified process flow, lower costs, and a better device performance. The latter is due to a backside drain electrode formation process, which does not require rapid thermal annealing. Lower on-state resistances can also be achieved. Finally, a better thermal management of the CAVET 100 is possible.

The solutions of the present disclosure, particularly the CAVET 100 as a whole, are applicable to semiconductor power devices, for instance, GaN-based power devices. Thereby, the following end-use applications are possible for the CAVET 100: AC adapters for faster charging and less heating for consumer electronics including mobile phones, laptops and etc.; data centers; EV chargers; PV inverters; motor control and uninterruptible power supply (UPS); and autonomous vehicles.

The present disclosure has been described in conjunction with various embodiments, examples, as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A current aperture vertical electron transistor, CAVET, (100) comprising:
a substrate (101);
a drift layer (102) of a first conductivity type arranged on or above the substrate (101);
a current blocking layer (103) of a second conductivity type arranged on the drift layer (102);
a diffusion blocking layer (104, 204) arranged on the current blocking layer (103), wherein the diffusion blocking layer (104, 204) comprises a semiconductor superlattice (104);
an aperture through the current blocking layer (103) and the diffusion blocking layer (104, 204), wherein the aperture exposes a surface portion of the drift layer (102);
a heterostructure arranged in the aperture on the exposed surface of the drift layer (102), and arranged on the diffusion blocking layer (104, 204), wherein the heterostructure comprises:
a channel layer (105), and
a barrier layer (106) arranged on the channel layer (105), and
a gate layer (107) of the second conductivity type arranged on the barrier layer (106);
wherein the CAVET (100) further comprises:
a gate electrode (108) arranged on the gate layer (107);
two source electrodes (109) arranged on the diffusion blocking layer (104, 204), wherein each end of a channel formed in the channel layer (105) at its interface to the barrier layer (106) is electrically connected to one of the source electrodes (109); and
a drain electrode (110) arranged on a surface of the substrate (101) that is opposite the drift layer (102).

2. The CAVET (100) of claim 1, wherein:
the drift layer (102) is a n-doped gallium nitride, GaN, layer;
the current blocking layer (103) is a p-doped GaN layer;
the semiconductor superlattice (104) comprises alternating aluminum nitride, A1N, layers (502) and aluminum gallium nitride, AlGaN, layers (501),
the channel layer (105) is an undoped or unintentionally doped GaN layer and the barrier layer (106) is an undoped or
unintentionally doped AlGaN layer; and
the gate layer (107) is a p-doped GaN layer.

3. The CAVET (100) of claim 2, wherein the semiconductor superlattice (104) further comprises GaN layers (601).

4. The CAVET (100) of claim 2 or 3, wherein an Al content in the AlGaN layers (501) of the semiconductor superlattice (104) is in a range of 1-99 %.

5. The CAVET (100) of one of the claims 2 to 4, wherein an Al content in the AlGaN layers (501) of the semiconductor superlattice (104) is graded.

6. The CAVET (100) of claim 5, wherein:
each AlGaN layer (501) of the semiconductor superlattice (104) is arranged between an A1N layer (502) and a GaN layer (601) of the semiconductor superlattice (104); and
the Al content of each AlGaN layer (501) gradually decreases from 100% at the interface between the AlGaN layer (501) and the A1N layer (502) to 0% at the interface between the AlGaN layer (501) and the GaN layer (601).

7. The CAVET (100) of one of the claims 2 to 6, wherein a thickness of each semiconductor superlattice (104) layer is in a range of 1-50 nm.

8. The CAVET (100) of one of the claims 2 to 7, wherein a total thickness of the semiconductor superlattice (104) is in a range of 2-1000 nm.

9. The CAVET (100) of one of the claims 1 to 8, wherein the diffusion blocking layer (104, 204) further comprises a semiconductor layer (204) of the second conductivity type arranged between the semiconductor superlattice (104) and the heterostructure, wherein a doping profile in the semiconductor layer (204) is graded.

10. The CAVET (100) of claim 9, wherein the semiconductor layer (204) of the diffusion blocking layer (104, 204) is a carbon-doped GaN layer.

11. The CAVET (100) of claim 10, wherein the carbon doping of the carbon-doped GaN layer (204) gradually decreases in a direction away from the semiconductor superlattice (104).

12. The CAVET (100) of claim 10 or 11, wherein a thickness of the carbon-doped GaN layer (204) is in a range of 50-1500 nm.

13. The CAVET (100) of one of the claims 1 to 12, wherein the substrate (101) is a silicon carbide, SiC, substrate of the first conductivity type.

14. The CAVET (100) of one of the claims 1 to 12, wherein:
the substrate (101) comprises a polycrystalline 3C-SiC bottom layer (401) and a single crystalline SiC or GaN top layer (402) arranged on the bottom layer (401); and
the drain contact (110) is arranged on the bottom layer (401).

15. The CAVET (100) of claim 14, wherein the 3C-SiC bottom layer (401) is degenerately doped with a doping concentration above 1e20 cm⁻³.

16. A current aperture vertical electron transistor, CAVET, (100) comprising:
a substrate (101) of the first conductivity type comprising a 3C-SiC polycrystalline bottom layer (401) and a single crystalline SiC or GaN top layer (402) arranged on the bottom layer (401);
a GaN drift layer (102) of a first conductivity type arranged on or above the SiC or GaN top layer (402) of the substrate (101);
a GaN current blocking layer (103) of a second conductivity type arranged on the GaN drift layer (102);
a diffusion blocking layer (104, 204) arranged on the GaN current blocking layer (103);
an aperture through the GaN current blocking layer (103) and the diffusion blocking layer (104, 204), wherein the aperture exposes a surface portion of the GaN drift layer (102);
a heterostructure arranged in the aperture on the exposed surface of the GaN drift layer (102), and arranged on the diffusion blocking layer (104, 204), wherein the heterostructure comprises:
a GaN channel layer (105); and
an AlGaN barrier layer (106) arranged on the GaN channel layer (105);
a GaN gate layer (107) of the second conductivity type arranged on the AlGaN barrier layer (106);
wherein the CAVET (100) further comprises:
a gate electrode (108) arranged on the GaN gate layer (107);
two source electrodes (109) arranged on the diffusion blocking layer (104, 204), wherein each end of a channel formed in the channel layer (105) at its interface to the barrier layer (106) is electrically connected to one of the source electrodes (109); and
a drain electrode (110) arranged on a surface of the bottom layer (401) of the substrate (101) that is opposite the top layer (402).

17. The CAVET (100) of claim 16, wherein the diffusion blocking layer (104, 204) comprises a semiconductor superlattice (104) that includes alternating AlGaN layers (501), GaN layers (601) and AlN layers (502).

18. A method (800) for fabricating a CAVET (100), the method (800) comprising:
forming (801) a substrate (101);
forming a drift layer (102) of a first conductivity type on or above the substrate (101);
forming a current blocking layer (103) of a second conductivity type on the drift layer (102);
forming a diffusion blocking layer (104, 204) on the current blocking layer (103), wherein the diffusion blocking layer (104, 204) comprises a semiconductor superlattice (104);
forming an aperture through the current blocking layer (103) and the diffusion blocking layer (104, 204), wherein the aperture exposes a surface portion of the drift layer (102);
forming a heterostructure in the aperture on the exposed surface of the drift layer (102), and on the diffusion blocking layer (104, 204), wherein forming the heterostructure comprises:
forming a channel layer (105), and
forming a barrier layer (106) on the channel layer (105), and
forming a gate layer (107) of the second conductivity type on the barrier layer (106); and
wherein the method (800) further comprises:
forming a gate electrode (108) on the gate layer (107);
forming two source electrodes (109) on the diffusion blocking layer (104, 204), wherein each end of a channel formed in the channel layer (105) at its interface to the barrier layer (106) is electrically connected to one of the source electrodes (109); and
forming a drain electrode (110) on a surface of the substrate (101) that is opposite the drift layer (102); wherein the semiconductor superlattice (104) of the diffusion blocking layer is grown (802) at a temperature in a range of 900-1200 °C.

19. A method (900) for fabricating a CAVET (100), the method (900) comprising:
forming (901) a substrate (101) of the first conductivity type comprising a 3C-SiC polycrystalline bottom layer (401) and a single crystalline SiC or GaN top layer (402) arranged on the bottom layer (401);
forming a GaN drift layer (102) of a first conductivity type on or above the SiC or GaN top layer (402) of the substrate (101);
forming a GaN current blocking layer (103) of a second conductivity type on the GaN drift layer (102);
forming a diffusion blocking layer (104, 204) on the GaN current blocking layer (103);
forming an aperture through the GaN current blocking layer (103) and the diffusion blocking layer (104, 204), wherein the aperture exposes a surface portion of the GaN drift layer (102);
forming a heterostructure in the aperture on the exposed surface of the GaN drift layer (102), and on the diffusion blocking layer (104, 204), wherein forming the heterostructure comprises:
forming a GaN channel layer (105); and
forming an AlGaN barrier layer (106) on the GaN channel layer (105); and
forming a GaN gate layer (107) of the second conductivity type on the AlGaN barrier layer (106);
wherein the method (900) further comprises:
forming a gate electrode (108) on the GaN gate layer (107);
forming two source electrodes (109) on the diffusion blocking layer (104, 204), wherein each end of a channel formed in the GaN channel layer (105) at its interface to the AlGaN barrier layer (106) is electrically connected to one of the source electrodes (109); and
forming a drain electrode (110) on a surface of the bottom layer (401) of the substrate (101) that is opposite the top layer (102);
wherein the drain electrode (110) is formed using an annealing-free process on the 3C-SiC bottom layer (401) of the substrate (101).

## Amended claims

### Amended claims in accordance with Rule 137(2) EPC.

1. A current aperture vertical electron transistor, CAVET, (100) comprising:
a substrate (101);
a drift layer (102) of a first conductivity type arranged on or above the substrate (101);
a current blocking layer (103) of a second conductivity type arranged on the drift layer (102);
a diffusion blocking layer (104, 204) arranged on the current blocking layer (103), wherein the diffusion blocking layer (104, 204) comprises a semiconductor superlattice (104);
an aperture through the current blocking layer (103) and the diffusion blocking layer (104, 204), wherein the aperture exposes a surface portion of the drift layer (102);
a heterostructure arranged in the aperture on the exposed surface of the drift layer (102), and arranged on the diffusion blocking layer (104, 204), wherein the heterostructure comprises:
a channel layer (105), and
a barrier layer (106) arranged on the channel layer (105), and
a gate layer (107) of the second conductivity type arranged on the barrier layer (106);
wherein the CAVET (100) further comprises:
a gate electrode (108) arranged on the gate layer (107);
two source electrodes (109) arranged on the diffusion blocking layer (104, 204), wherein each end of a channel formed in the channel layer (105) at its interface to the barrier layer (106) is electrically connected to one of the source electrodes (109); and
a drain electrode (110) arranged on a surface of the substrate (101) that is opposite the drift layer (102);
wherein the diffusion blocking layer (104, 204) further comprises a semiconductor layer (204) of the second conductivity type arranged between the semiconductor superlattice (104) and the heterostructure, wherein a doping profile in the semiconductor layer (204) is graded.

2. The CAVET (100) of claim 1, wherein:
the drift layer (102) is a n-doped gallium nitride, GaN, layer;
the current blocking layer (103) is a p-doped GaN layer;
the semiconductor superlattice (104) comprises alternating aluminum nitride, AlN, layers (502) and aluminum gallium nitride, AlGaN, layers (501),
the channel layer (105) is an undoped or unintentionally doped GaN layer and the barrier layer (106) is an undoped or
unintentionally doped AlGaN layer; and
the gate layer (107) is a p-doped GaN layer.

3. The CAVET (100) of claim 2, wherein the semiconductor superlattice (104) further comprises GaN layers (601).

4. The CAVET (100) of one of the claims 2 to 43 wherein an Al content in the AlGaN layers (501) of the semiconductor superlattice (104) is graded.

5. The CAVET (100) of claim 4, wherein:
each AlGaN layer (501) of the semiconductor superlattice (104) is arranged between an AlN layer (502) and a GaN layer (601) of the semiconductor superlattice (104); and
the Al content of each AlGaN layer (501) gradually decreases from 100% at the interface between the AlGaN layer (501) and the AlN layer (502) to 0% at the interface between the AlGaN layer (501) and the GaN layer (601).

6. The CAVET (100) of one of the claims 2 to 5, wherein a thickness of each semiconductor superlattice (104) layer is in a range of 1-50 nm.

7. The CAVET (100) of one of the claims 2 to 6, wherein a total thickness of the semiconductor superlattice (104) is in a range of 2-1000 nm.

8. The CAVET (100) of one of the claims 1 to 7, wherein the semiconductor layer (204) of the diffusion blocking layer (104, 204) is a carbon-doped GaN layer.

9. The CAVET (100) of claim 8, wherein the carbon doping of the carbon-doped GaN layer (204) gradually decreases in a direction away from the semiconductor superlattice (104).

10. The CAVET (100) of claim 8 or 9, wherein a thickness of the carbon-doped GaN layer (204) is in a range of 50-1500 nm.

11. The CAVET (100) of one of the claims 1 to 10, wherein the substrate (101) is a silicon carbide, SiC, substrate of the first conductivity type.

12. The CAVET (100) of one of the claims 1 to 10, wherein:
the substrate (101) comprises a polycrystalline 3C-SiC bottom layer (401) and a single crystalline SiC or GaN top layer (402) arranged on the bottom layer (401); and
the drain contact (110) is arranged on the bottom layer (401).

13. The CAVET (100) of claim 12, wherein the 3C-SiC bottom layer (401) is degenerately doped with a doping concentration above 1e20 cm⁻³.

14. A method (800) for fabricating a CAVET (100), the method (800) comprising:
forming (801) a substrate (101);
forming a drift layer (102) of a first conductivity type on or above the substrate (101);
forming a current blocking layer (103) of a second conductivity type on the drift layer (102);
forming a diffusion blocking layer (104, 204) on the current blocking layer (103), wherein the diffusion blocking layer (104, 204) comprises a semiconductor superlattice (104);
forming an aperture through the current blocking layer (103) and the diffusion blocking layer (104, 204), wherein the aperture exposes a surface portion of the drift layer (102);
forming a heterostructure in the aperture on the exposed surface of the drift layer (102), and on the diffusion blocking layer (104, 204), wherein forming the heterostructure comprises:
forming a channel layer (105), and
forming a barrier layer (106) on the channel layer (105), and
forming a gate layer (107) of the second conductivity type on the barrier layer (106); and
wherein the method (800) further comprises:
forming a gate electrode (108) on the gate layer (107);
forming two source electrodes (109) on the diffusion blocking layer (104, 204), wherein each end of a channel formed in the channel layer (105) at its interface to the barrier layer (106) is electrically connected to one of the source electrodes (109), and
forming a drain electrode (110) on a surface of the substrate (101) that is opposite the drift layer (102); wherein the semiconductor superlattice (104) of the diffusion blocking layer is grown (802) at a temperature in a range of 900-1200 °C;
wherein forming the diffusion blocking layer (104, 204) further comprises forming a semiconductor layer (204) of the second conductivity type arranged between the semiconductor superlattice (104) and the heterostructure, wherein a doping profile in the semiconductor layer (204) is graded.
